# EUROPEAN PATENT SPECIFICATION

(11) **EP 1 983 528 B1**
(45) Date of publication and mention of the grant of the patent: **03.08.2016**
(21) Application number: 07706716.3
(22) Date of filing: 09.01.2007
(51) Int. Cl.: H01B 5/14, H01B 13/00, H01L 31/0224, H01L 31/0392, C23C 18/08

(54) **SILVER CONDUCTIVE FILM AND PRODUCTION METHOD THEREOF**
LEITENDER SILBERFILM UND HERSTELLUNGSVERFAHREN DAFÜR
FILM CONDUCTEUR EN ARGENT ET PROCEDE POUR LE PRODUIRE

(30) Priority: 11.01.2006 JP 2006003171; 24.02.2006 JP 2006049358
(43) Date of publication of application: 22.10.2008
(73) Proprietor: DOWA Electronics Materials Co., Ltd., Chiyoda-ku Tokyo 101-0021 (JP)
(72) Inventor: SATO, Kimitaka, Saitama 367-0002 (JP); HISAEDA, Yutaka, Saitama 367-0042 (JP); OKANO, Taku, Saitama 360-0045 (JP); OGI, Kozo, Saitama 367-0021 (JP)
(74) Representative: Emde, Eric
(86) International application number: PCT/JP2007/050375
(87) International publication number: WO 2007/080997

(56) References cited:
- WO-A1-2005/023702
- JP-A- 06 204 535
- JP-A- 09 246 577
- JP-A- 10 294 483
- JP-A- 2000 091 606
- JP-A- 2005 002 387

## Description

### TECHNICAL FIELD

The present invention relates to a silver conductive film suitable for the rear-surface, electrode-side conductive layer of a thin-film solar cell, and to a production method thereof.

### PRIOR ART

A thin-film solar cell has a large light absorption coefficient in the photoelectric conversion layer thereof and has a high incident light utilization efficiency, as compared with a bulk-type solar cell, and is therefore advantageous in that the amount of the silicon material to be used may be reduced. In addition, it is further characterized in that its photoelectric conversion layer may be formed at a relatively low temperature and its environmental load is small.

A solar cell effectively utilizes the incident light thereto, and therefore it is effective to form a texture structure in the incident plane thereby lowering the reflectance on the surface so as to reduce the loss by reflection. In a bulk-type solar cell, it is possible to form a texture structure directly in the silicon surface of the photoelectric conversion layer. However, in a thin-film solar cell, the thickness of the photoelectric conversion layer is, for example, at most 500 nm or so and is thin, and therefore it is difficult to form a texture directly in the incident plane of the cell, and accordingly in this, the transparent electrode adjacent to the light-receiving surface of the photoelectric conversion layer is roughened to have fine projections and recesses, thereby forming the intended texture therein.

For the thin-film solar cell, a method is also effective, which comprises reflecting the light that could not be absorbed by the photoelectric conversion layer on the layer on the side of the back surface and again returning it to the photoelectric conversion layer. For example, Patent Reference 1 describes a method for forming a reflective film, which comprises using a metal and/or a metal-containing substance as a target and applying a bias direct current voltage to a substrate with changing it, thereby forming an electrode film having a high reflectance. Patent Reference 2 describes a method of forming a thin, aluminium oxide-containing Ag conductive film, according to a vacuum film formation process of sputtering or vacuum evaporation or the like. In Patent Reference 3, proposed is a method that comprises forming a lower electrode layer on a substrate by the use of a dispersion of ultrafine metal particles, then forming an upper electrode layer by the use of a dispersion having a higher metal concentration than the dispersion used in forming the previous lower electrode layer, and baking it at a temperature of from 300 to 650°C.
Patent Reference 1 Japanese Patent No. 3337918
Patent Reference 2 JP-A 2005-2387
Patent Reference 3 JP-A 9-246577

### PROBLEMS THAT THE INVENTION IS TO SOLVE

In Patent Reference 1, the bias direct current voltage to be applied to the substrate in sputtering is so controlled that it is weak in the initial stage of film formation and is then gradually increased, thereby giving a reflective layer having a higher reflectance. However, in case where a film is formed in a vacuum film formation process, a low pressure of at most 10⁻⁶ Torr (high vacuum degree) is needed for attaining film uniformity and for preventing contamination with impurities, but this is problematic in point of the tact time and the production cost.

The advantage of the method of Patent Reference 2 is that a silver conductive film having a texture structure can be obtained, not requiring a high temperature of 400°C or higher. However, as using a vacuum film formation process, this also requires a low pressure of at most 10⁻⁶ Torr (high vacuum degree) like in Patent Reference 1.

Patent Reference 3 employs a process of film formation by non-vacuum coating, and is therefore more advantageous in point of the production cost than a vacuum film formation process; however, this requires repeated overcoating in plural times and requires baking at 300°C or higher for obtaining the texture structure, and therefore, this is still problematic in point of the tact time. In addition, this has another problem in that the type of the substrate applicable thereto is limited.

In consideration of these prior-art problems, the present invention is to provide a conductive film suitable for the rear-surface electrode of a thin-film solar cell, especially a flexible substrate-having thin-film solar cell, and excellent in industrial producibility. Concretely, its object is to provide a conductive film having a low resistance and a high reflectance, having a texture structure, excellent in the adhesiveness to substrate and capable of being produced in a non-vacuum atmosphere at lower than 300 deg. C, and a production method thereof.

Furthermore, WO 2005 023 702 A1 relates to metal nano-particles, a method for producing the same and a metal film made thereof. According to this document, a specific method for producing a dispersion containing metal nano-particles in a concentration of not less than 5% by mass and not more than 90% by mass is described. The resulting dispersion is applied onto the surface of a base material, followed by drying the applied layer of the dispersion and then firing the dried layer of the dispersion at a low temperature to thus form a thin metallic wire or a metal film having conductivity.

### MEANS FOR SOLVING THE PROBLEMS

In accordance with the present invention, a method for producing a thin conductive film of silver on a substrate as set forth in claim 1 is provided. Fruther embodiments of the invention are inter alia disclosed in the dependent claims. To attain the above-mentioned object, the invention provides a thin film of silver (silver conductive film) formed on a substrate. The thin film comprises, for example, sintered silver particles having a mean particle size DTEM of at most 100 nm, and has a texture structure having a surface roughness Ra of from 10 to 100 nm. In addition, the thin film has a dense structure. More particularly, for example, this is densified by the mechanical compression stress given thereto after sintering, and has a dense structure of such that the density of the voids seen in the cross section of the film is 3/µm² or less. Having the dense structure, the silver conductive film has excellent adhesiveness to substrate. For example, when tested in an adhesiveness test with a Cellophane adhesive tape to be mentioned hereinafter, its adhesiveness is that the survival ratio of 1-mm² cross-cuts is at least 90 %. The specific resistance is, for example, at most 5 µΩ*cm and is low. The mean film thickness of the silver conductive film is, for example, from 50 to 2000 nm; and a preferred embodiment of the film is such that no carbon is detected inside the layer thereof (in the region having a sputtering depth from the surface of at least 5 nm in terms of SiO₂) in ESCA (electron spectroscopy for chemical analysis). This gives no carbon energy peak at 284.3 eV and 284.5 eV in ESCA inside the layer having a depth of at least 5 nm from the outermost surface thereof.

The silver conductive film having such a texture structure can be produced according to a production process that comprises a step of applying a silver coating material of silver particles with a mean particle size D_{TEM} of at most 100 nm dispersed in a non-polar or poorly-polar liquid organic medium having a boiling point of from 60 to 300°C, onto a substrate to form a coating film thereon, a step of baking the coating film to form a baked film, and a step of compression-forming the baked film.

More specifically, herein employable is a production method for a silver conductive film, which comprises a step of reducing a silver compound (for example, silver nitrate) in an alcohol having a boiling point of from 80 to 200°C or in a polyol having a boiling point of from 150 to 300°C, using the alcohol or the polyol as a reducing agent, in the presence of an organic compound such as an amine having one or more unsaturated bonds in one molecule, within a temperature range of from 80 to 200°C, thereby precipitating silver particles, a step of collecting the silver particles and mixing them with a non-polar or poorly-polar liquid organic medium having a boiling point of from 60 to 300°C to give a slurry, and processing the slurry for solid-liquid separation to collect a dispersion of silver particles having a mean particle size D_{TEM} of at most 100 nm, a step of applying a silver coating material of the dispersion onto a substrate to form a coating film thereon, a step of baking the coating film to form a baked film, and a step of compression-forming the baked film. The terms "Comprising a step of ..." above mean that the production process includes the above-mentioned steps in the above-described order. The baking temperature may be from 100°C to lower than 300°C. Accordingly, the silver particles are sintered to form a silver film. In the compression-forming, preferably, a pressure of from 5 to 200 N/cm² is applied to the surface of the baked film.

The mean particle size D_{TEM} is a mean particle diameter as determined through observation of the silver particle dispersion with a transmission electronic microscope (TEM). At least 300 independent particles not overlapping with any other particles in the TEM image are randomly selected, the particle size of each particle (the diameter of the circumscribed circle having a smallest diameter of the circumscribed circles that surround the particle appearing in the image) is measured, and the data are averaged through computation to give the mean particle size.

The terms "Non-polar or poorly-polar" mean that the specific dielectric constant at 25°C is at most 15.

The invention has made it possible to form a silver conductive film having a low resistance and few voids and having a texture structure, on a film substrate, in a non-vacuum atmosphere at a low temperature of lower than 300°C. The texture structure of the silver conductive film exhibits an excellent function as a reflective layer on the rear-surface electrode side in a thin-film solar cell. As having a low resistance, this also contributes toward increasing the conversion efficiency of a thin-film solar cell; and since there are few voids in the silver conductive film, there are also few voids in the interface between the silver conductive film and the substrate with the result that the adhesiveness of the film to the substrate is excellent. Since a silver conductive film not substantially containing carbon may be obtained, there occurs no gas generation to be caused by carbon in the production process for solar cells, and void formation in the layer formed on the silver conductive film may be prevented. In addition, those not containing a substance of sulfur, chlorine or the like that corrodes wirings and electronic parts may also be obtained. Further, in production of the silver conductive film, large-area film formation is possible under the above-mentioned non-vacuum and low-temperature condition, and therefore, mass-production of silver conductive films is possible within a short tact time and at a low cost. Accordingly, the invention contributes toward further popularization of thin-film solar cells.

### BRIEF DESCRIPTION OF THE DRAWINGS

Fig. 1 shows SEM picture of the cross section of the silver conductive film obtained in Example 1.
Fig. 2 shows SEM picture of the cross section of the silver conductive film obtained in Comparative Example 1.
Fig. 3 shows SEM picture of the cross section of the silver conductive film obtained in Comparative Example 2.

### PREFERRED EMBODIMENTS OF THE INVENTION

The inventors found that, according to a process of reducing a silver compound in an alcohol or a polyol in the presence of an organic protective agent, silver nano-particles (particles having a particle size of at most 100 nm) of extremely good dispersibility in a low-polar liquid organic medium can be obtained, and disclosed it as Japanese Patent Application Nos. 2005-26805, 2005-26866, 2005-56035 and 2005-222855. As a result of further studies made afterwards, the inventors have found that, when a dispersion of such silver particles is applied onto a substrate of a polyimide resin or the like to form a coating film thereon and the coating film is baked, then the silver, though having a melting point of about 961°C, is sintered at a low temperature of from 100°C to lower than 300°C, thereby stably forming a silver conductive film having a specific resistance of at most 5 µΩ·cm and having a texture structure having a surface with Ra of from 10 to 100 nm. In addition, compression-forming the silver conductive film formed by the baking, with rolls or the like gives a silver conductive film having a ratio of voids in the sintered layer of at most 3/µm². The film thickness may be from 50 to 2000 nm.

### [Surface Roughness Ra]

In case where the surface roughness Ra of the silver conductive film is less than 10 nm, the surface of the thin film has high smoothness and therefore shows a high reflectance to the incident light thereto, but since the light scattering on the film surface is small, the reflected light could not be sufficiently absorbed by a semiconductor layer into its inside but may be led out of the system with the result that the incident light could not be effectively utilized and the improvement of power generation efficiency could not be expected. On the contrary, when the surface roughness Ra is too large, then the transparent conductive film layer for preventing the short circuit in a solar cell will have to be thick and accordingly the light absorption loss by it may increase. In any case, therefore, the conversion efficiency of solar cells could not be fully enhanced. As opposed to this, in case where the film has a texture structure with a surface roughness Ra of from 10 to 100 nm, the optical path length may be prolonged by the light scattering that occurs on the surface of the thin film and the light absorption efficiency may be thereby increased, and accordingly, the conversion efficiency may be improved, resulting in the increase in the power generation per the unit area of thin-film solar cells.

### [Specific Resistance]

Having a lower resistance, the silver conductive film may attain more efficient power collection at a small loss of power generated in a photoelectric conversion layer. As a result of various investigations, the inventors have found that those having a reduced specific resistance of at most 5 µΩ·cm are extremely effective for the increase in power generation per the unit area owing to the increase in the conversion efficiency of thin-film solar cells. More preferably, the specific resistance is at most 4 µΩ·cm, even more preferably at most 3 µΩ·cm, still more preferably at most 2 µΩ·cm.

### [Density of Voids]

When the fewer are the voids in a silver conductive film, the fewer are the voids in the interface between the silver conductive film and a substrate, therefore resulting in that the contact area between the silver conductive film and the substrate may increase and the adhesiveness between them may be thereby increased. As a result of various investigations, when the density of voids that can be seen in the cross section as cut in parallel to the film thickness direction of a silver conductive film is at most 3/µm², then the adhesiveness to the substrate such as polyimide film or the like can be noticeably improved.

### [Adhesiveness to Substrate]

Thin-film solar cells are installed outdoors; and when once installed, they are used for a long period of time. In addition, in particular, since it is theoretically impossible to repair the silver conductive film part after production, the film is required to have high durability. The durability means that the film has sufficient adhesion strength (adhesiveness) between it and a substrate and an upper layer that are in contact with it. The adhesiveness may be evaluated according to the following adhesiveness test.

Adhesiveness Test:
A silver conductive film formed on a substrate is cut with a cutter knife to form 1 mm²-size 100 cross-cuts, then a Cellophane adhesive tape (this is defined in JIS Z1522, and has an adhesive amount of about 8 N per a width of 25 mm) is stuck thereto under hand pressure, and then this is peeled off, whereupon the number, x, of the remaining cross-cuts is counted. With that, the survival ratio (%), as computed by (x/100)×100, is determined. The adhesiveness of the silver conductive film to the substrate may be evaluated according to this survival ratio. Specifically, silver conductive films having a survival ratio of at least 90 % may be considered to have sufficient durability enough for practical use. In this case, it may be considered that the silver conductive film may also have a sufficient adhesiveness between it and an upper layer that is to be in contact with it on the side opposite to the side of the substrate. More preferably, the survival ratio is at least 95 %, even more preferably 100 %. When the survival ratio is less than 90 %, then the reliability of the film may be low and, for example, the resistance may lower in long-term use or in an accelerated test, and attention must be paid thereto. In forming the cross-cuts, attention must be paid so as not to cut the substrate.

The silver conductive film has a texture structure suitable for the reflective layer on the rear-surface electrode side of a thin-film solar cell, and in addition, since it may be formed in a process of "coating to baking", those having a large area may be produced with ease, and the baking may be attained at a low temperature lower than 300°C.

The silver conductive film may be produced according to the process mentioned below.

### [Formation of Silver Particles]

An alcohol having a boiling point of from 80 to 200°C or a polyol having a boiling point of from 150 to 300°C is prepared. The alcohol or the polyol functions as a reaction medium and a reducing agent for a silver compound in the invention. As the alcohol, usable are propyl alcohol, isopropyl alcohol, n-butanol, isobutanol, sec-butyl alcohol, tert-butyl alcohol, allyl alcohol, crotyl alcohol, cyclopentanol, etc. The polyol is an organic substance having plural hydroxyl groups, and may be referred to as a polyalcohol. As the polyol, usable are diethylene glycol, triethylene glycol, tetraethylene glycol, etc. A polyol derivative may also be used as a solvent. The derivative shall be within the scope of the polyol.

The silver compound used includes silver nitrate, silver oxide, silver carbonate, etc. From the industrial viewpoint, silver nitrate is easy to use. During the reaction, the Ag ion concentration in the liquid may be at least 0.05 mol/L, preferably from 0.05 to 5.0 mol/L.

As the organic compound, herein used is an amine compound having at least one or more unsaturated bonds in one molecule and having a molecular weight of from 100 to 1000, preferably from 100 to 400. It may be presumed that, when such an amine compound having an unsaturated bond is used, then there may occur a phenomenon of generating silver nuclei all at a time in the reduction reaction and wholly homogeneously controlling the growth of the precipitated silver nuclei, and as a result, a powder of silver particles having a particle size of at most 100 nm or at most 50 nm may be obtained at a high yield. In addition, since the amine compound decomposes at a relatively low temperature, the low-temperature sinterability of the silver particle dispersion may be secured. Typical amine compounds usable in the invention are, for example, triallylamine, oleylamine, dioleylamine, oleylpropylenediamine.

A reduction promoter may be used. As the reduction promoter, usable is an amine compound having a molecular weight of from 100 to 1000, and for example, of amine compounds, secondary and tertiary amines having a strong reducing force are preferred. Of those, especially preferred for use herein are diethanolamine and triethanolamine.

The reduction is preferably attained under a reflux condition under which an alcohol or a polyol serving both as a reaction medium and as a reducing agent is repeatedly evaporated and condensed under heat. In this case, the above-mentioned organic compound may be present in the liquid, whereby silver particles coated with the organic compound may be produced. The molar ratio of the alcohol or polyol/Ag may be within a range of from 0.5 to 50. The molar ratio of the organic compound/Ag may be within a range of from 0.05 to 5. In case where a reduction promoter is used, the molar ratio of the reduction promoter/Ag may be within a range of from 0.1 to 20.

### [Preparation of Silver Particle Dispersion]

After the above-mentioned reduction reaction, the slurry is processed for solid-liquid separation with, for example, a centrifuge, and the separated liquid is discarded and the solid component is collected. The solid component is mixed with an organic solvent such as methanol, and then further processed for solid-liquid separation with a centrifuge, and the separated liquid is discarded and the solid component is collected. If desired, this washing operation is repeated, and the finally obtained solid component (precipitate) is collected. The solid component mainly comprises a powder of silver particles coated with an organic compound. This is mixed with a liquid organic medium.

As the liquid organic medium, herein used is a non-polar or poorly-polar liquid organic medium having a boiling point of from 60 to 300°C. "Non-polar or poorly-polar" as referred to therein means that the specific dielectric constant at 25°C is at most 15, more preferably at most 5. In case where the specific dielectric constant is high, it is unfavorable since the dispersibility of the silver particles may worsen and they may precipitate. Depending on the use of the dispersion, various liquid organic mediums may be used; but for use as conductive films on the rear-surface electrode side of solar cells, preferred are hydrocarbons, for example, aliphatic hydrocarbons such as isooctane, n-decane, isododecane, isohexane, n-undecane, n-tetradecane, n-dodecane, tridecane, hexane, heptane, and aromatic hydrocarbons such as benzene, toluene, xylene, ethylbenzene, decalin, tetralin. One or more types of those liquid organic mediums may be used, and they may be a mixture such as kerosene. Further, for controlling the polarity, a polar organic medium such as alcohol-type, ketone-type, ether-type or ester-type ones may be added within a range within which the mixed liquid organic medium may have a specific dielectric constant at 25°C of at most 15.

The liquid of a liquid organic medium mixed with a powder of silver particles is processed for solid-liquid separation, for example, with a centrifuge, and in this stage, the solid component is discarded and the separated liquid is collected. In this liquid, silver particles having a small silver particle distribution are dispersed. If desired, the concentration of the dispersion is controlled, and a final silver particle dispersion (silver coating material) is thus obtained.

The mean particle size D_{TEM} of the silver particles in the dispersion is at most 100 nm, but preferably at most 50 nm, more preferably at most 30 nm, and as the case may be, even more preferably at most 20 nm. The mean particle size D_{TEM} may be controlled by the molar ratio of the alcohol or polyol/Ag, the molar ratio of the organic compound/Ag, the molar ratio of the reduction promoter/Ag, the heating speed in reduction, the stirring force, the type of the silver compound, the type of the alcohol or polyol, the type of the reduction promoter, the type of the organic compound, etc.

Preferably, the silver concentration in the dispersion is from 5 to 90 % by mass or so. Also preferably, the viscosity of the dispersion is from 1 mPa·s to 100 Pa·s or so.

### [Formation of Silver Conductive Film]

As the substrate on which a silver conductive film is formed, usable is an organic polymer film. The thickness of the organic polymer film is not specifically defined; but preferably, the film has flexibility enough for a roll-to-roll process. Also preferred are those having high heat resistance, for example, including polyethylene terephthalate, polyethylene naphthalate, polyimide, aramide, polycarbonate.

The above-mentioned silver particle dispersion is applied onto the substrate. The coating method is not specifically defined, so far as it may produce a coating film capable of giving a baked silver conductive film having a thickness of from 50 to 2000 nm. The coating may be attained according to screen printing, inkjet printing, spin coating, roll coating, slit coating, spray coating, etc.

Next, the coating film thus formed is baked so as to sinter the silver particles, thereby giving a baked film of silver. The baking atmosphere may be an oxidative atmosphere (for example, air) under normal pressure. The silver particles in the coating film may be sintered at an extremely low temperature, and the baking temperature may be within a range of from 100°C to lower than 400°C; however, from the viewpoint of energy saving, it is within a temperature range of from 100°C to lower than 300°C. When the producibility is taken into consideration, not a batch-type apparatus but a continuous baking apparatus applicable to a roll-to-roll system suitable to mass-production is preferably used. For example, its examples are a hot air circulating drying unit, a belt-type baking furnace, and an IR baking furnace. Regarding the baking time, it is desirable that the substrate with a coating film formed thereon is kept within the above-mentioned temperature range for at least 30 minutes, more preferably for at least 60 minutes. However, keeping it too long may interfere with the producibility, and therefore, in general, the time may be within a range of at most 300 minutes.

In case where the silver conductive film is used in thin-film solar cells, its adhesiveness to the substrate must be sufficiently high, and therefore, after baked, the film is compression-formed. Not specifically defined, herein usable is any apparatus capable of giving compression of at least 5 N/cm² to the baked silver conductive film; but in consideration of the producibility, not a batch-type pressing apparatus but a continuous compression apparatus applicable to a roll-to-roll system suitable to mass-production is preferably selected. For example, a calender roll is usable. The pressure in compression-forming with the roll may be determined by dividing the load given by the roll by the contact area between the roll and the baked film. The pressure may be defined within a range of from 5 to 200 N/cm². Regarding the heating in compression-forming, the temperature may be from room temperature (approximately 25°C or so) to the glass transition temperature of the substrate film.

In the manner as above, a silver conductive film may be formed, having a texture structure with a surface roughness Ra (arithmetical mean roughness) of from 10 to 100 nm and having a specific resistance of at most 5 µΩ·cm. The silver conductive film having Ra that falls within the range, when used as a rear-surface, electrode-side conductive layer in a thin-film solar cell, may scatter and reflect the light not absorbed by the photoelectric conversion layer therein, and may again return it to the photoelectric conversion layer. Accordingly, the optical path length may be prolonged, and the light absorption by the photoelectric conversion layer is promoted and the conversion efficiency in the solar cell is enhanced. More preferably, the surface roughness Ra is from 20 to 60 nm. The surface roughness Ra may be controlled by the baking temperature and the pressure in compression-forming. When the baking temperature is high, then Ra may too much increase, and attention should be paid thereto.

Compression-forming the baked film in the manner as above may give a silver conductive film having a density of voids in the cross section thereof of at most 3/µm². The silver conductive film of the type is excellent in the conversion efficiency and in the adhesiveness to substrate, as so mentioned in the above.

For use as the rear-surface, electrode-side conductive layer in a thin-film solar cell, the mean thickness of the silver conductive layer is preferably from 50 to 2000 nm, more preferably from 50 to 1000 nm.

### EXAMPLES

### [Example 1]

200 mL of isobutanol (Wako Pure Chemical's special grade chemical) serving both as a reaction medium and as a reducing agent, 27 mL of oleylamine (by Wako Pure Chemical, Mw = 267) as an organic compound, and 13.7 g of silver nitrate crystal (by Kanto Chemical) as a silver compound were prepared, and these were mixed and stirred with a magnet stirrer to dissolve the silver nitrate.

The solution was transferred into a container equipped with a reflux condenser, and set in an oil bath. With a flow of nitrogen gas as an inert gas jetted into the container at a flow rate of 400 mL/min, the solution was heated with stirring with a magnet stirrer at a revolution speed of 100 rpm. The heating rate up to 100°C was 2°C/min. At a temperature of 100°C, this was refluxed for 3 hours, and then 8.5 g (molar ratio to Ag, 1.0) of a secondary amine, diethanolamine (by Wako Pure Chemical, Mw = 106) as a reduction promoter was added to it. Next, this was kept as such for 1 hour, and the reaction was finished. After the reaction, the slurry was processed for solid-liquid separation with a centrifuge, and the separated liquid was discarded, and the solid component was collected. Next, the solid component was mixed with methanol and then further processed for solid-liquid separation with a centrifuge, and the separated liquid was discarded and the solid component was collected. The washing cycle was repeated twice.

N-dodecane (boiling point: about 210°C) was prepared as a liquid organic medium having a specific dielectric constant at 25°C of at most 15. This was mixed with the washed solid component, then processed for solid-liquid separation with a centrifuge for 30 minutes, and the separated liquid was collected. Silver particles are dispersed in this liquid. The silver particle dispersion was observed with TEM. Using the image observed at a magnification of about 600,000-power, the mean particle size D_{TEM} of the silver particles was determined according to the above-mentioned method. In addition, the viscosity of the liquid was measured with a rotary viscometer (Toki Sangyo's RE550L). As a result, the silver particle dispersion had the following characteristics:
Silver concentration: 63.5 % by mass.
Viscosity: 4.2 mPa·s.
Mean particle size D_{TEM} of the dispersed silver particles: 9 nm.

A polyimide film (Ube Industries's Upilex, having a thickness of about 25 µm) was prepared as a substrate. The above-mentioned silver dispersion was applied onto the substrate, using an applicator, and then baked at 200°C for 60 minutes, using a hot air drier. As a result of observation, the silver particles were sintered. Thus obtained, the baked silver film was, together with the polyimide film, compression-formed using a calender roll (Yasui Seiki's SC3-100) under a pressure of 20 N/cm² to give a silver conductive film. Regarding the heating in compression-forming, the roll surface temperature was 80°C.

The mean film thickness of the thus-obtained silver conductive film was measured, using a fluorescent X-ray film-thickness gauge (SII's SFT9200).

The surface roughness of the silver conductive film was measured, using a non-contact two/three-dimensional micro-profile analyzer (Kosaka Laboratory's ET-30HK).

The specific resistance of the silver conductive film was determined through computation from the surface resistance measured with a surface resistance meter (Mitsubishi Chemical's Loresta HP) and the film thickness measured with the film-thickness gauge.

The void density of the silver conductive film was determined as follows: The cross section of the film worked by FIB (JEOL's JEM-9310FIB) was observed with FE-SEM (JEOL's JSM-6700F), and from the number of the voids and the observed area, the void density was determined through computation.

Using ESCA (Ulvac-Phi's ESCA5800) under the condition mentioned below, the silver conductive film was checked for the presence or absence of carbon energy peaks at 284.3 eV and 284.5 eV in a depth region of at least 5 nm in terms of SiO₂ from the outermost surface of the film.

### (ESCA Analysis Condition)

X-ray source: Al anode ray source, 1500 W.

Analysis area: 400 µmφ.

Neutralization gun: used.

Take-out angle: 45°.

Ar sputtering etching speed: 40 nm/min (as SiO₂).

In addition, according to the adhesiveness test method mentioned in the above, the silver conductive film was checked for the adhesiveness thereof to the polyimide film substrate. The number, x, of the remaining ones of 100 cross-cuts was counted, and the survival ratio (%) represented by (x/100) × 100 was computed. The samples having a survival ratio of at least 90 % were evaluated good for the adhesiveness, and the others were evaluated bad for the adhesiveness.

As a result, the properties of the silver conductive film (after compression-formed) were as follows:
Mean film thickness: about 900 nm.
Specific resistance: 3.6 µΩ·cm.
Ratio of voids: 2.5/µm².
Surface roughness Ra: 28 nm.
Presence or absence of carbon: absence (not detected).
Adhesiveness: survival ratio 100 % (all cross-cuts remained, good).

Accordingly, the silver conductive film had a good resistance value and a texture structure, not containing carbon to cause voids, and had a low void density, and its adhesiveness to the substrate was good.

### [Comparative Example 1]

The same silver particle dispersion as in Example 1 was applied onto a polyimide film (the same as in Example 1) using an applicator, and then baked at 180°C for 60 minutes using a hot air drier, thereby forming a silver conductive film. As a result of observation, the silver particles were sintered.

The obtained silver conductive film (baked only) was evaluated in the same manner as in Example 1, and as a result, the properties of the silver conductive film were as follows:
Mean film thickness: about 940 nm.
Specific resistance: 4.4 µΩ·cm.
Ratio of voids: 5.0/µm².
Surface roughness Ra: 96 nm.
Presence or absence of carbon: absence (not detected).
Adhesiveness: survival ratio 0 % (no cross-cut remained, bad).

Accordingly, the silver conductive film had a good resistance value and a texture structure, not containing carbon to cause voids; however, it had a high ratio of voids, and its adhesiveness to the substrate was insufficient.

### [Comparative Example 2]

The same silver particle dispersion as in Example 1 was applied onto a polyimide film (the same as in Example 1) using an applicator, and then baked at 220°C for 60 minutes using a hot air drier, thereby forming a silver conductive film. As a result of observation, the silver particles were sintered.

The obtained silver conductive film (baked only) was evaluated in the same manner as in Example 1, and as a result, the properties of the silver conductive film were as follows:
Mean film thickness: about 1240 nm.
Specific resistance: 2.1 µΩ·cm.
Ratio of voids: 4.7/µm².
Surface roughness Ra: 95 nm.
Presence or absence of carbon: absence (not detected).
Adhesiveness: survival ratio 68 % (bad).

Accordingly, the silver conductive film had a good resistance value and a texture structure, not containing carbon to cause voids; however, it had a high ratio of voids, and its adhesiveness to the substrate was insufficient.

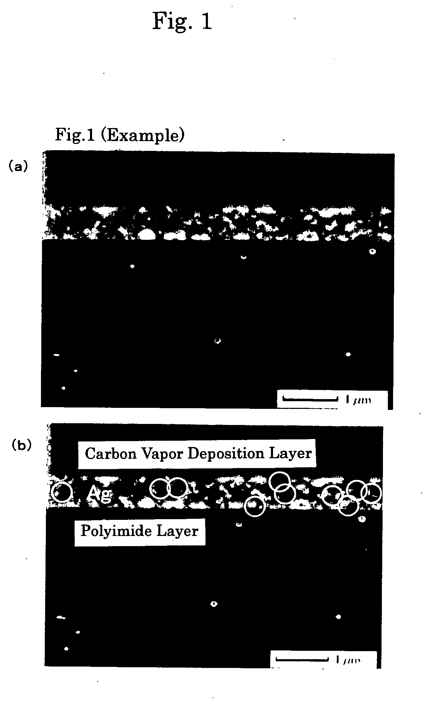

Figs. 1 to 3 each show SEM pictures of the cross section of the silver conductive film obtained in Example 1, Comparative Example 1 and Comparative Example 2, respectively. In these, (b) is a sketch of the photograph (a).

The silver conductive film of Example 1 (Fig. 1) was compression-formed after the film formation, and in this, therefore, the small particles were crushed and there were few voids. 10 voids in total were seen at the sites marked by "○" in Fig. 1(b); and the number was divided by the cross-sectional area, 4.0 µm² of the silver conductive film (expressed as Ag in the drawing) in this field of vision, whereby the void density was 2.5/µm² as in the above.

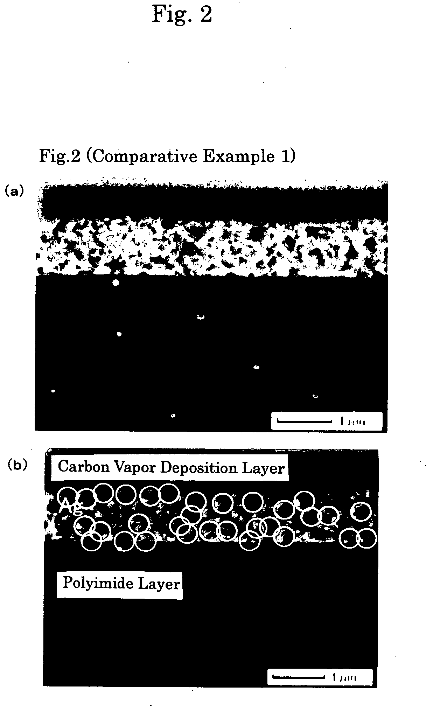

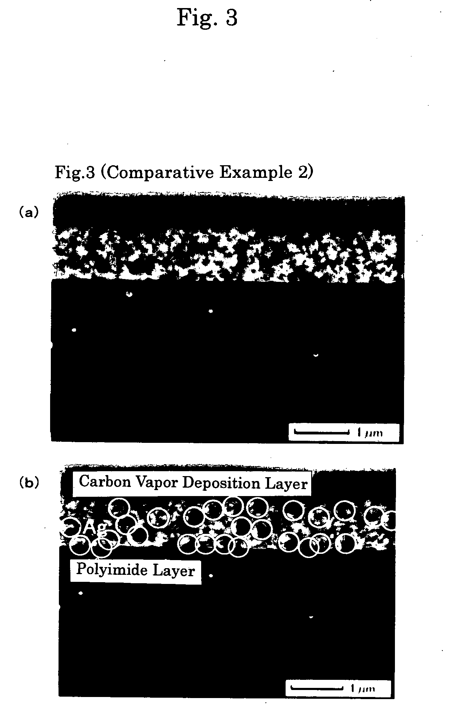

The silver conductive films of Comparative Example 1 (Fig. 2) and Comparative Example 2 (Fig. 3) were baked only but were not compression-formed, and therefore, in these, there were a large number of voids. In Comparative Example 2 in which the baking temperature was 220°C and was relatively high, the size of each void tended to be large as compared with that in Comparative Example 1 in which the temperature was 180°C. In Comparative Example 1, 31 voids in total were seen at the sites marked with "○" in Fig. 2(b); and the number was divided by the cross-sectional area, 6.2 µm² of the silver conductive film in this field of vision, whereby the void density was 5.0/µm² as in the above. In Comparative Example 2, 27 voids in total were seen at the sites marked with "○" in Fig. 3(b); and the number was divided by the cross-sectional area, 5.8 µm² of the silver conductive film in this field of vision, whereby the void density was 4.7/µm² as in the above.

## Claims

1. A method for producing a thin conductive film of silver on a substrate such that the thin film comprises sintered silver particles, has a density of the voids seen in the cross section of the film of at most 3/µm² and a texture structure with a surface roughness Ra of from 10 to 100 nm, the method comprising:
a step of applying a silver coating material of a dispersion of silver particles having a mean particle size D_{TEM} of at most 100 nm dispersed in a non-polar or poorly-polar liquid organic medium having a boiling point of from 60 to 300°C, onto a substrate to form a coating film thereon,
a step of baking the coating film so as to sinter the silver particles, thereby forming a baked film, and
a step of densifying the baked film by applying a mechanical compression stress to achieve the density of the voids seen in the cross section of the film of at most 3/µm².

2. The method for producing a silver conductive film of claim 1, further comprising producing the dispersion of silver particles by reducing a silver compound in an alcohol having a boiling point of from 80 to 200°C or in a polyol having a boiling point of from 150 to 300°C, using the alcohol or the polyol as a reducing agent, in the presence of an organic compound having one or more unsaturated bonds in one molecule, within a temperature range of from 80 to 200°C, thereby precipitating silver particles, a step of collecting the silver particles and mixing them with a non-polar or poorly-polar liquid organic medium having a boiling point of from 60 to 300°C to give a slurry, and processing the slurry for solid-liquid separation to collect a dispersion of silver particles having a mean particle size D_{TEM} of at most 100 nm.

3. The method of producing a silver conductive film as claimed in claim 1 or 2, wherein the specific resistance of the silver conductive film is at most 5 µΩ*cm.

4. The method of producing a silver conductive film as claimed in any of claims 1 to 3, wherein no carbon is detected inside the layer having a depth of at least 5 nm from the surface thereof.

5. The method of producing a silver conductive film as claimed in any of claims 1 to 4, wherein a mean film thickness of the silver conductive film is from 50 to 2000 nm.

6. The method of producing a silver conductive film as claimed in claim 2, wherein the organic compound is an amine compound.

7. The method of producing a silver conductive film as claimed in any of claims 1 to 6, wherein the coating film is baked within a temperature range of from 100°C to lower than 300°C.

8. The method of producing a silver conductive film as claimed in any of claims 1 to 7, wherein the mechanical compression stress imparts a pressure of from 5 to 200 N/cm² to the surface of the baked film.

## Patentansprüche

1. Verfahren zur Herstellung eines dünnen leitenden Silberfilms auf einem Substrat, so dass der dünne Film gesinterte Silberpartikel aufweist, eine Leerstellendichte gesehen im Querschnitt des Films von höchstens 3/µm² und eine Texturstruktur mit einer Oberflächenrauheit Ra von 10 bis 100 nm hat, wobei das Verfahren Folgendes aufweist:
einen Schritt des Aufbringens eines Silberbeschichtungsmaterials einer Dispersion von Silberpartikeln mit einer mittleren Partikelgröße D_{TEM} von höchstens 100 nm verteilt in einem nicht polaren oder schwach polaren flüssigen organischen Medium mit einem Siedepunkt von 60 bis 300°C auf einem Substrat, um einen Beschichtungsfilm darauf zu formen,
einen Schritt des Backens des Beschichtungsfilms, um die Silberpartikel zu sintern, wodurch ein gebackener Film gebildet wird, und
einen Schritt einer Verdichtung des gebackenen Films durch Aufbringen einer mechanischen Druckspannung, um die Leerstellendichte, gesehen im Querschnitt des Films, von höchstens 3/µm² zu erreichen.

2. Verfahren zur Herstellung eines leitenden Silberfilms nach Anspruch 1, welches weiter Folgendes aufweist: Erzeugen der Dispersion von Silberpartikeln indem eine Silberverbindung in einem Alkohol mit einem Siedepunkt von 80 bis 200°C oder in einem Polyol mit einem Siedepunkt von 150 bis 300°C reduziert wird, und zwar unter Verwendung des Alkohols oder Polyols als Reduzierungsmittel, in Anwesenheit einer organischen Verbindung mit einer oder mehreren ungesättigten Bindungen in einem Molekül innerhalb eines Temperaturbereichs von 80 bis 200°C, wodurch Silberpartikel ausgefällt werden, einen Schritt des Sammelns der Silberpartikel und des Mischens dieser mit einem nicht polaren oder schwach polaren flüssigen organischen Medium mit einem Siedepunkt von 30 bis 300°C, um eine Schlämmung zu erhalten, und des Verarbeitens der Schlämmung zur Feststoff-Flüssigkeit-Trennung, um eine Dispersion von Silberpartikeln mit einer mittleren Partikelgröße von D_{TEM} von höchstens 100 nm zu sammeln bzw. zu erzeugen.

3. Verfahren zur Herstellung eines leitenden Silberfilms nach Anspruch 1 oder 2, wobei der spezifische Widerstand des leitenden Silberfilms höchstens 5µΩ*cm ist.

4. Verfahren zur Herstellung eines leitenden Silberfilms nach einem der Ansprüche 1 bis 3, wobei kein Kohlenstoff in der Schicht detektiert wird, die eine Tiefe von mindestens 5 nm von der Oberfläche davon hat.

5. Verfahren zur Herstellung eines leitenden Silberfilms nach einem der Ansprüche 1 bis 4, wobei die mittleren Filmdicke des leitenden Silberfilms von 50 bis 2000 nm ist.

6. Verfahren zur Herstellung eines leitenden Silberfilms nach Anspruch 2, wobei die organische Verbindung eine Aminverbindung ist.

7. Verfahren zur Herstellung eines leitenden Silberfilms nach einem der Ansprüche 1 bis 6, wobei der Beschichtungsfilm in einem Temperaturbereich von 100°C bis weniger als 300°C gebacken wird.

8. Verfahren zur Herstellung eines leitenden Silberfilms nach einem der Ansprüche 1 bis 7, wobei die mechanische Druckspannung einen Druck von 5 bis 200 N/cm² auf die Oberfläche des gebackenen Films aufbringt.

## Revendications

1. Procédé pour fabriquer un film mince conducteur en argent sur un substrat, de telle sorte que le film mince comprenne des particules d'argent frittées, ait une densité de lacunes dans une coupe du film d'au plus 3/um² et une structure de texture ayant une rugosité de surface Ra comprise entre 10 et 100 nm, le procédé comprenant :
une étape consistant à appliquer un matériau de revêtement d'argent d'une dispersion de particules d'argent ayant une taille moyenne de particule D_{TEM} d'au plus 100 nm, dispersée dans un milieu organique liquide non polaire ou faiblement polaire ayant un point d'ébullition compris entre 60 et 300 °C, sur un substrat pour former un film de revêtement sur celui-ci,
une étape consistant à cuire le film de revêtement de façon à fritter les particules d'argent, formant ainsi un film cuit, et
une étape consistant à densifier le film cuit en appliquant une contrainte de compression mécanique pour obtenir une densité des lacunes vue dans la coupe du film d'au plus 3/um².

2. Procédé pour fabriquer un film conducteur en argent selon la revendication 1, comprenant en outre la fabrication de la dispersion des particules d'argent en réduisant un composé d'argent dans un alcool ayant un point d'ébullition compris entre 80 et 200 °C ou dans un polyol ayant un point d'ébullition compris entre 150 et 300 °C, en utilisant l'alcool ou le polyol comme agent réducteur, en présence d'un composé organique ayant une ou plusieurs liaisons non saturées dans une même molécule, dans une plage de température comprise entre 80 et 200 °C, précipitant ainsi les particules d'argent, une étape consistant à recueillir les particules d'argent et à les mélanger avec un milieu organique liquide non polaire ou faiblement polaire ayant un point d'ébullition compris entre 60 et 300 °C pour obtenir une suspension, et traiter la suspension pour une séparation solide-liquide pour recueillir une dispersion de particules d'argent ayant une taille moyenne de particule D_{TEM} d'au plus 100 nm.

3. Procédé pour fabriquer un film conducteur en argent selon la revendication 1 ou 2, dans lequel la résistance spécifique du film conducteur en argent est au plus de 5 µΩ*cm.

4. Procédé de fabrication d'un film conducteur en argent selon l'une quelconque des revendications 1 à 3, dans lequel aucun carbone n'est détecté à l'intérieur de la couche ayant une profondeur d'au moins 5 nm par rapport à la surface de celui-ci.

5. Procédé de fabrication d'un film conducteur en argent selon l'une quelconque des revendications 1 à 4, dans lequel l'épaisseur moyenne du film conducteur en argent est comprise entre 50 et 2000 nm.

6. Procédé pour fabriquer un film conducteur en argent selon la revendication 2, dans lequel le composé organique est un composé amine.

7. Procédé de fabrication d'un film conducteur en argent selon l'une quelconque des revendications 1 à 6, dans lequel le film de revêtement est cuit dans une plage de température comprise entre 100 °C et moins que 300 °C.

8. Procédé de fabrication d'un film conducteur en argent selon l'une quelconque des revendications 1 à 7, dans lequel la contrainte de compression mécanique exerce une pression comprise entre 5 et 200 N/cm² sur la surface du film cuit.
